Europäisches Patentamt

European Patent Office

Office européen des brevets

(11) Publication number: **0 444 658 A2**

# EUROPEAN PATENT APPLICATION

(21) Application number: **91102993.2**

(22) Date of filing: **28.02.91**

(51) Int. Cl.5: **H01J 37/34**

(30) Priority: **28.02.90 JP 48404/90**
  **10.04.90 JP 94750/90**

(43) Date of publication of application:
  **04.09.91 Bulletin 91/36**

(84) Designated Contracting States:
  **DE GB NL**

(71) Applicant: **ANELVA CORPORATION**
  **8-1 Yotsuya 5-chome**
  **Fuchu-shi Tokyo 183(JP)**

(72) Inventor: **Yoshida, Hideaki**
  **c/o ANELVA Corporation, 8-1, Yotsuya
  5-chome
  Fuchu-shi, Tokyo(JP)**

Inventor: **Akao, Yasuhiko**
**432-1, Kamisugata-cho, Hodogaya-ku
Yokohama-shi, Kanagawa(JP)**
Inventor: **Kouchi, Haruyuki**
**c/o ANELVA Corporation, 8-1, Yotsuya
5-chome
Fuchu-shi, Tokyo(JP)**
Inventor: **Takahashi, Nobuyuki**
**c/o ANELVA Corporation, 8-1, Yotsuya
5-chome
Fuchu-shi, Tokyo(JP)**

(74) Representative: **Freiherr von Schorlemer,
Reinfried, Dipl.-Phys.
Patentanwalt Brüder-Grimm-Platz 4
W-3500 Kassel(DE)**

(54) **Magnetron sputtering apparatus and thin film depositing method.**

(57) A magnetron cathode sputtering apparatus provides an increased strength of the magnetic field around the center area of a target (2) when the sputtering occurs on the target, thereby reducing any dust particles that might settle on the center target area and might be flying toward a wafer (1) or each individul substrate thereon, resulting in forming or depositing a thin film containing defects such as pin holes on the wafer. A magnetron cathod sputtering method uses such apparatus to form or deposit a thin film layer on the wafer, with its distribution limited to within ± 5%. and provides an improved step coverage for the contact holes formed in each individual substrate on the wafer, from which any irregularities can be eliminated.

FIG. 1

## BACKGROUND OF THE INVENTION

### Field of the Invention

The present invention relates to a magnetron sputtering apparatus that may be used for depositing or forming a thin film on a wafer or each individual substrate thereon in order to fabricate semi-conductor devices or electronic components, such as magnetic disc, optical disc and magnet-optical disc. It also relates to a method of depositing or forming a thin film on the wafer or each individual substrate thereon by making use of such magnetron sputtering apparatus.

### Description of the Prior Art

A typical magnetron sputtering apparatus that is known to the relevant prior art has been used widely, because of its simple construction, high productivity, and good reproducibility.

Specifically, a single wafer process type of a magnetron sputtering apparatus that is designed for fabricating semiconductor devices has the following advantages:

(1) It can increase the rate at which a thin film or layer is deposited or formed on the wafer, and can minimize the effects of any impure gases that may be produced during that process. This provides the good quality thin films on the wafer; and

(2) It allows a thin film to be formed within the wafer or each individual substrates on the wafer in the controlled manner, and provides the identical profile, or geometrical configuration, for the thin film formed within every individual substrate on the wafer.

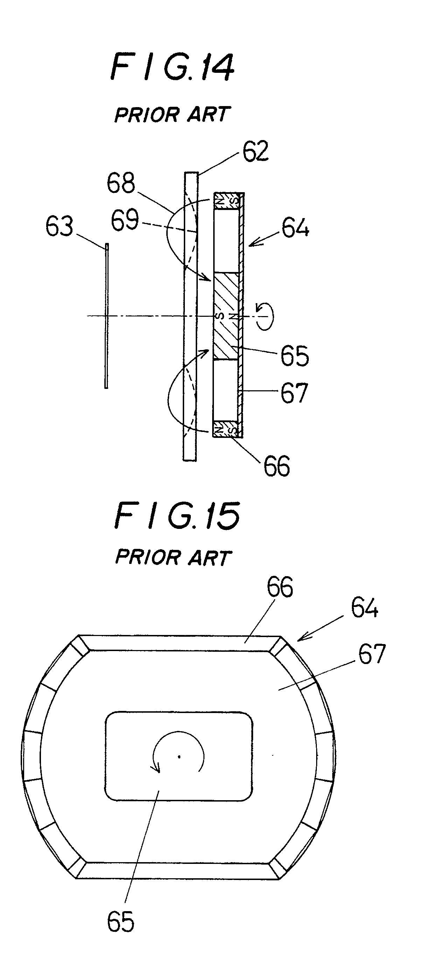

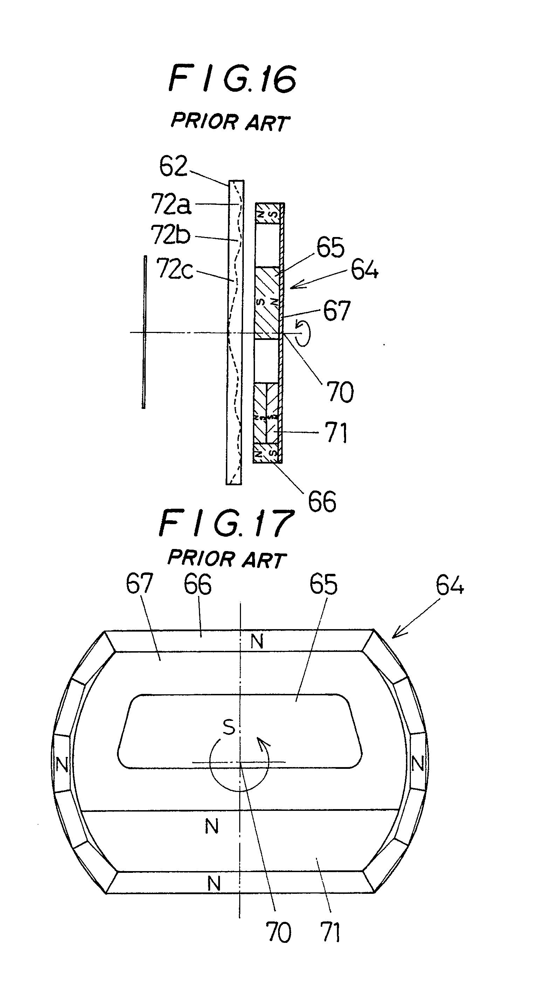

Figs. 14 and 15 represent the typical prior art magnetron sputtering apparatus that has been used so far for the above particular purposes, which comprises a magnetron cathode including a circular target material 62, and a wafer 63 which contains individual substrates thereon. Those are placed with a specific spacing therebetween, with the one facing opposite the other. The magnetron cathode also includes means 64 for producing a magnetic field, which is placed behind the circular target material 62 and is capable of rotation. While the magnetic field producing means 64 is rotating, a discharge is produced between the circular target material 62 and the wafer 63. This discharge provides the sputtering action upon the circular target material, so that a thin film can be formed or deposited on the wafer or each individual substrate thereon.

The magnetic field producing means 64 includes a center magnetic pole 65 and an annular magnetic pole 66 surrounding the outer circumferential edge of the center magnetic pole 65, both poles being connected on a yoke 67. The assembly 64 provides forces of magnetic lines as shown by 68 which develop a magnetic field across the circular target 62. The circular target material undergoes the sputtering action which forms an annular erosion region 69 as shown by the dotted lines on the surface of the target 62. This annular erosion region 69 is formed by rotating the magnetic field producing assembly 64.

Figs. 16 and 17 show another prior art magnetron sputtering apparatus which also has been used in these years. This apparatus provides improvement over the apparatus shown in Figs. 14 and 15. For the apparatus shown in Figs. 16 and 17, the magnetic field producing assembly 64 which is placed behind the circular target 62 has the construction that is different from that of the assembly 64 for the earlier described apparatus. Specifically, the magnetic field producing assembly 64 includes an annular magnetic pole 66 which is disposed around the circumference of a yoke 67, and a center magnetic pole 65 which is off its center axis of rotation 70 toward one side as shown Fig. 17. On the side opposite the side on which center magnetic pole 65 is located, there are two auxiliary magnetic poles 71 which are placed one over the other inside the annular magnetic pole 66.

The prior art magnetron sputtering apparatus shown in Figs. 16 and 17 has the following constructional features that may be distinguished from the prior art apparatus shown in Figs. 14 and 15. As shown in Figs. 16 and 17, the center magnetic pole 65, which is formed like a plate having the rectangular shape, is off the center axis of rotation 70 of the magnetic field producing assembly 64 toward one side thereof, and the auxiliary plate poles 71 (which are made of rubber sheets containing impregnated ferrite and are placed one over another) are disposed inside the annular pole 66. The number of those auxiliary plate poles 71, as well as the direction of the magnetic field developed by each of the sheets, may be changed. The erosion region (the portion of the target material that is eroded by sputtering) that appears on the surface of the circular target 62 consists of triple concentric circles 72a, 72b, 72c, as shown by the dotted lines in Fig. 16. This makes it possible to make effective use of the target material, whose utilization may amount to about 58%.

As described, the apparatus shown in Figs. 16 and 17 provides improvement over the apparatus shown in Figs. 14 and 15, in that the target material can be utilized more effectively. Also, it can improve the step coverage for contact holes formed in, and the distribution of thin films formed over, the wafer or all individual substrates thereon, as compared with the apparatus in Figs. 14 and 15.

The problem of dust particles that may originate in the target material and may be transported through the spacing onto the wafer, eventually settling on the wafer or individual substrates thereon, remains unsolved.

It should also be noted that, according to the improvement in Figs. 16 and 17, the sputtering cannot cover all the areas of the circular target material, with some areas of the target located around its center being less or not subjected to the sputtering action. It is noticed that dust particles tend to settle on those areas, adhesively or not. The dust particles are thus easily transported from those areas toward the wafer or individual substrates thereon, during the sputtering process. When those dust particles will have settled on the thin films formed on some substrates on the wafer, they may affect the quality of those particular substrates, which may contain defects such as pin holes.

Another problem occurs with the contact holes formed in the wafer or each individual substrate thereon during the sputtering process. With the apparatus shown in Figs. 16 and 17, it is difficult to provide a uniform thin film coating over all of the formed contact holes. The coverage for the contact holes, which are located at various points on the wafer, may become irregular. A further problem is the irregular thin film coating for each individual contact hole.

SUMMARY OF THE INVENTION

It may be appreciated from the preceding description that the apparatus shown in Figs. 16 and 17 may provide some degree of improvement over the apparatus shown in Figs. 14 and 15, in respect of the above problems, but it is recognized that that apparatus must be improved further to meet the recent requirements for the higher density and integration of the semiconductor devices.

In the light of the problems that have been described so far, it is accordingly the object of the present invention to provide the magnetron sputtering apparatus that provides further improvement in the sputtering capabilities so that they can sputter all areas of the target material, including the center areas in particular, and can minimize the chances of any dust particles being settled, adhesively or not, on some particular areas, such as the center areas, of the target.

Another object of the present invention is to provide a method of forming or depositing a thin film on a wafer or each individual substrate thereon, by using the magnetron sputtering apparatus according to the above object of the present invention, whereby a uniform or regular step coverage can be provided for the contact holes formed at various locations through the wafer, and the thin film coating formed or deposited can be distributed uniformly or evenly over the whole wafer or each of the individual substrates thereon.

The present invention consists essentially of increasing the strength of the magnetic field around the center area of a target material being subjected to the sputtering action, thereby ensuring that the center area material can also fully be processed by sputtering.

In its specific form, the magnetron sputtering apparatus according to the present invention includes a magnetic field producing assembly which is provided rotatably, including a center magnetic pole disposed behind a circular target material and an annular magnetic pole disposed around the outer circumferential edge of the center magnetic pole, the center magnetic pole and annular magnetic pole being coupled on a yoke, wherein the improvement further includes auxiliary magnetic poles that supplement the center pole and annular pole for enhancing the strength of the magnetic field onto the center areas of the circular target.

The method according to the present invention consists of forming or depositing a thin film on a wafer or each individual substrate thereon, by making use of the magnetron sputtering apparatus. The erosion that can be formed on the cicular target has the profile or geometric configuration containing a double circle. The two circles are formed concentrically on their common axis, each having its respective peak point between 15/152b to 20/152b and between 50/152b to 60/152b (where "b" is the diameter of the circular target). The inner circle and outer circle have the erosion strength ratio of between 2:3 and 1:1 at their respective peak points.

The magnetron sputtering apparatus according to the present invention provides the strength of the magentic field around the center areas of the circular target that is sufficient to confine the plasma developed between the target and wafer during the sputtering process within the center target areas, thereby increasing the concentration of the plasma upon the center target areas. In this way, the center target areas can have the better sputtering effect, which can also sputter the remaining areas of the target fully. The result is the coverage of all target areas. This prevents any dust particles from settling on the target material, thereby reducing or minimizing the quantity of those dust particles that will be transported from the target onto the wafer or individual substrates thereon.

According to the method of the invention, a thin film layer distribution can extend into the depth of the wafer or individual substrates thereon, within the limit of ± 5%. The step coverage for the contact holes formed in the wafer or individual substrates thereon can be regular, and any irregularities that may occur in those contact holes can be reduced.

## BRIEF DESCRIPTION OF DRAWINGS

Those and other objects, features, and merits of the present invention will become more apparent from the remainder of the specification in which several preferred embodiments will fully be described with reference to the accompanying drawings, in which:

Fig. 1 is a longitudinal section view showing the principal components of the magnetron sputtering apparatus according to a preferred embodiment of the present invention;

Fig. 2 is a front view of means for developing a magnetic field in the embodiment of Fig. 1;

Fig. 2a is a front view of means for developing a magnetic field in other embodiment of the present invention;

Fig. 3 is a transversal section view showing the principal components in the embodiment of Fig. 1;

Fig. 4 is a diagram that shows the mangetic field distribution over a target in the embodiment of Fig. 1;

Fig. 5 is a diagram that shows the magnetic field distribution over a target in the prior art apparatus (such as the one shown in Figs. 16 and 17);

Fig. 6 is a graphical diagram that explains the relationships between the non-errosion region and the number of dust particles on a wafer in the particular embodiment of the present invention;

Fig. 7 is a diagram that shows the errosion profile for a target in the prior art apparatus;

Fig. 8 (a), (b) and (c) is a section view showing a contact hole portion as determined by the simulation calculation performed according to Fig. 7;

Fig. 9 (a), (b) and (c) are SEM photographs and corresponding schematic drawings showing the section across the metal structure in the substrate on which the thin film is deposited by using the prior art apparatus;

Fig. 10 is a diagram that shows the errosion profile for a target in the embodiment of Fig. 1 through Fig. 3;

Fig. 11 (a), (b) and (c) is a section view showing a contact hole portion as determined by the simulation calculation performed according to Fig. 10;

Fig. 12 (a), (b) and (c) are SEM photographs and corresponding schematic drawings showing the section across the metal structure in the substrate on which the thin film is deposited by using the apparatus of the present invention;

Fig. 13 is a graphical diagram showing the distribution of the thin film deposited by using the apparatus of the invention;

Fig. 14 is a section view showing the principal components of the prior art apparatus;

Fig. 15 is a front view showing the means for developing the magnetic field in the prior apparatus of Fig. 14:

Fig. 16 is a section view showing the principal components of another prior art apparatus; and

Fig. 17 is a front view showing the means for developing the magnetic field in the prior art apparatus of Fig. 16.

## DESCRIPTION OF PREFERRED EMBODIMENTS

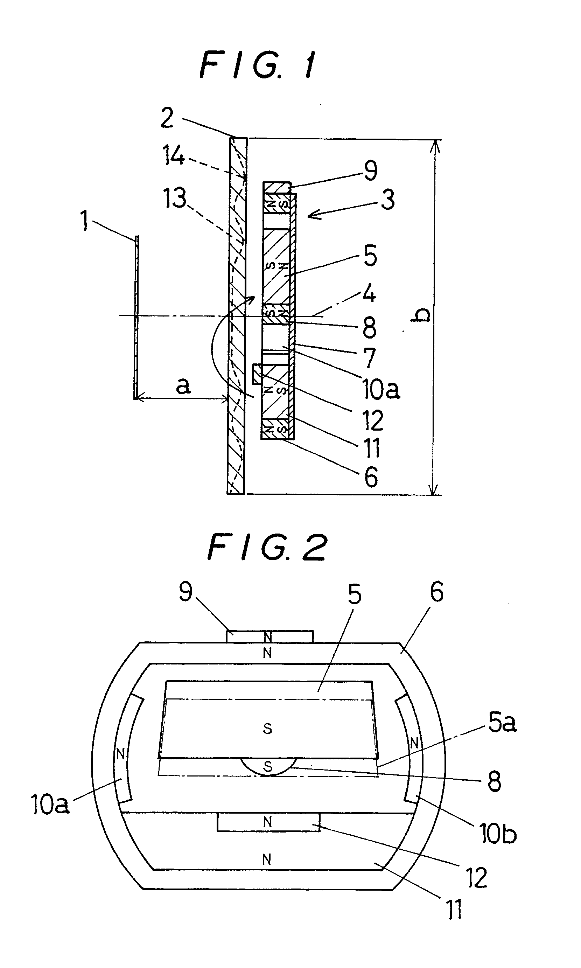

Referring first to Figs. 1 through 3, the magnetron sputtering apparatus according to the particular preferred embodiment of the present invention will be described in further details.

The apparatus includes a wafer 1 to be processed by sputtering, a cicular target 2, and means 3 for producing a magnetic field, all of which are arranged in the same manner as those in the prior art apparatus. The wafer 1 and the circular target 2 are placed in parallel, with the one facing opposite the other, and the magnetic field producing means 3 is placed behind the circular target 2. The means 3 is capable of rotating on its center axis 4.

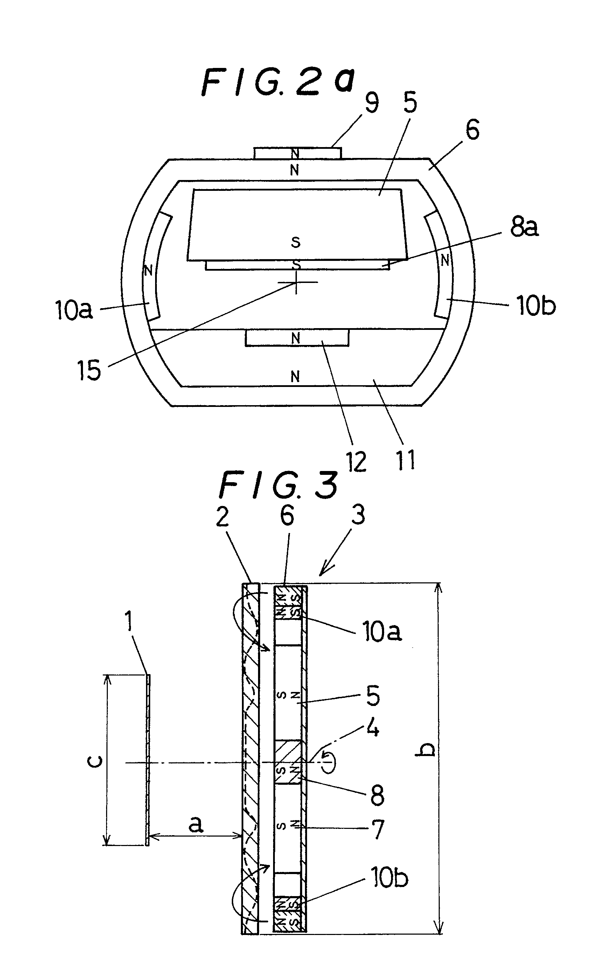

The magnetic field producing means 3 consists essentially of a center magnetic pole 5 for providing a south (S) polarity, and an annular magnetic pole 6 for providing a north (N) polarity and which surrounds the center magnetic pole 5. Those poles 5 and 6 are coupled together on a yoke 7. For the prior art apparatus (Figs. 16 and 17), the center magnetic pole 5 is placed as indicated by the dot-dash lines 5a in Fig. 2. In the embodiment of the present invention, however, the center magnetic pole 5 is off outwardly by about 15 mm, and an auxiliary magnetic pole 8 having the semi-circular cylindrical shape is provided inwardly of the center magnetic pole 5 (closer to the center axis).

The annular magnetic pole 6 also includes an auxiliary magnetic pole 9 (N polarity), which has the plate shape and is placed on the outer circumferential edge of the annular pole and on one side thereof, and two auxiliary magnetic poles 10a, 10b (N polarities), which have the plate shape and are placed on the opposite sides of the inner circumference of the annular magnetic pole 6. An additional auxiliary magnetic pole 11 (N polarity), which has the plate shape and is functionally equivalent to the auxiliary pole 71 in the prior art apparatus, is provided on the inner circumference of the annular magnetic pole 6 where the annular magnetic pole 6 faces opposite the auxiliary magnetic pole 8. An additional auxiliary magnetic pole 12 (N polarity) is provided on the inner edge of the auxiliary magnetic pole 11.

The auxiliary magnetic pole 8 may be replaced by the auxiliary magnetic plate pole 8a, as shown in Fig. 2a, and it may be placed so that it deviates from the center axis 15 of rotation of the magnetic field producing assembly 3.

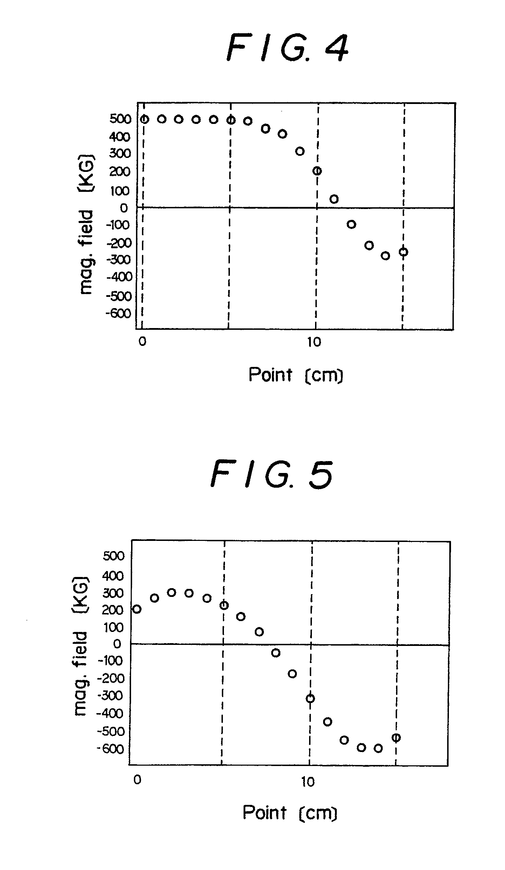

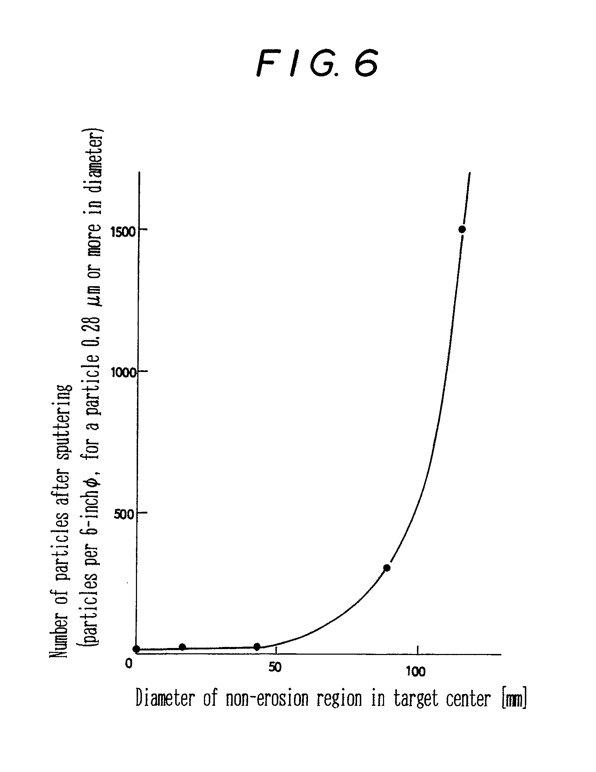

In the embodiment described above, the vertical magnetic field on the surface of the circular target 2 may have the distribution such as the one shown in Fig. 4 (as measured upwardly, beginning with the center axis 4 in Fig. 1). It may be appreciated from this magnetic field distribution that the magnetic field is stronger around the center area of the circular target, and is more extensive, than that in the magnetic field distribution for the prior art apparatus in Fig. 5. This results from the fact that the center pole 5 is off the center axis and the auxiliary pole 8 is provided.

The magnetic field around the center areas of the target is strong enough to confine the plasma developed between the wafer 1 and circular target 2 during the sputtering process, thereby allowing the center areas of the circular target to be subjected to the full sputtering process.

In practice, during the sputtering process, the magnetic field producing assembly 3 rotates at the particular speed as previously determined, and the magnetic field being developed in the sputtering space varies constantly as the magnetic field producing assembly 3 is rotating. This produces an erosion in the circular target 2, as shown by the dotted lines in Figs. 1 and 3. The deepest erosions 13, 14 appear as double concentric circles. The inner erosion circle 13 is equal to 0.23 times the reference radius of the circular target 2, and the outer erosion circle 14 is equal to 0.76 times the reference radius of the target 2. The utilization of the target material amounts to 48% of the total target. Presumably, the formation of the outer erosion circle 14 is due to the particular arrangement of the magnetic poles 10a, 10b. Similarly, the formation of the inner erosion circle 13 is due to the particular arrangement of the auxiliary magnetic poles 8, 9, and 12. It should be noted, in this case, that the diameter b of the circular target 2 is chosen such that it is equal to double the diameter c of the wafer 1, and the distance or spacing a between the wafer 1 and circular target 2 is chosen such that it is equal to about one-fourth the diameter b.

Fig. 6 represents the relationships between the non-erosion region (the region not affected by the sputtering action) and the number of dust particles that may settle on the circular target 2, when the non-erosion region around the center areas of the circular target 2 is varied by varying the strengths of the auxiliary magnetic poles 8, 9, 10a, 10b, 11, and 12, in accordance with the apparatus in the current embodiment.

The result shows that the number of dust particles will decrease drastically as the non-erosion region is reduced. It may be appreciated that the number of dust particles can be reduced to zero (0) when the whole surface of the target is wholly eroded as described above for the embodiment of the present invention.

The following description provides the specific conditions under which a thin film is formed or deposited on a wafer or individual substrates thereon by using the apparatus according to the above described embodiment. Those conditions are simulated under which the running test takes place and a thin film is formed.

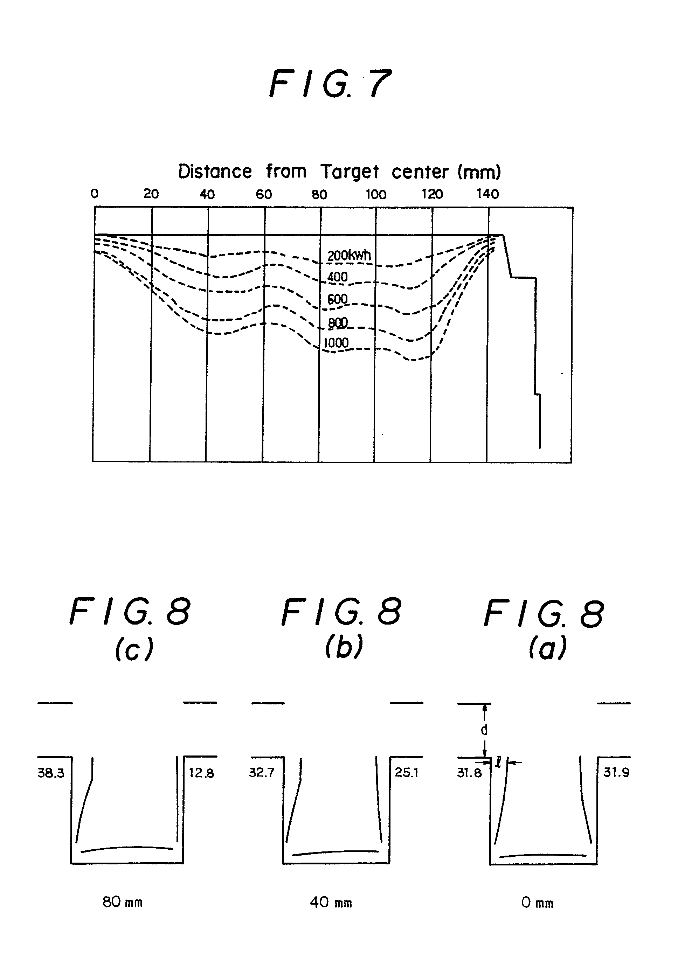

Initially, the running test (1,000 Kwh) takes place by using the prior art apparatus shown in Figs. 16 and 17, from which an erosion profile on a target as shown in Fig. 7 may be obtained. In this running test, the target has the diameter of 12 inches, the wafer has the diameter of 6 inches, and the distance between the wafer and target is 65 mm.

The results are obtained from the running test, as plotted in Fig. 7, from which the depth of erosion formed at every distance of 2 mm farther away from the target center may be determined. Assuming that the depth of each erosion is the strength of particles to be influenced by the sputtering action, and that the sputtered particles from every point of the erosion are flying toward the wafer or each individual substrate thereon according to the cosine law, the calculation may be performed to determine the layer of a thin film being deposited on the wafer.

This calculation assumes that the wafer contains contact holes of 1 $\mu$m diameter and 1$\mu$m depth at its center point and at points 40 mm and 80 mm away from the center, resepectively.

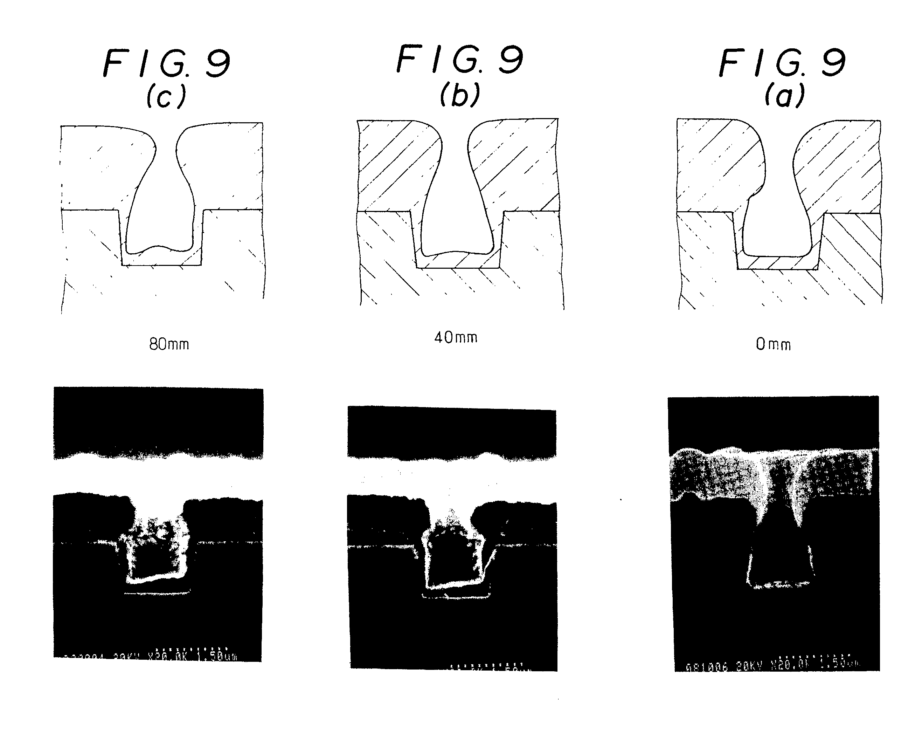

The results obtained from the calculation are shown in Fig. 8 (a), (b) and (c). In each of Fig. 9 (a), (b) and (c), the SEM photograph shows the thin film coating actually formed on the wafer, and the corresponding schematic drawing shows the cross-section across the contact hole. In those drawings, the upper part represents the schematic drawing, and the lower part represents the photograph. Fig. 9 (a) represents the contact hole located in the target center, Fig. 9 (b) represents the contact hole located 40mm away from the target center, and Fig. 9 (c) represents the contact hole located 80 mm away from the target center.

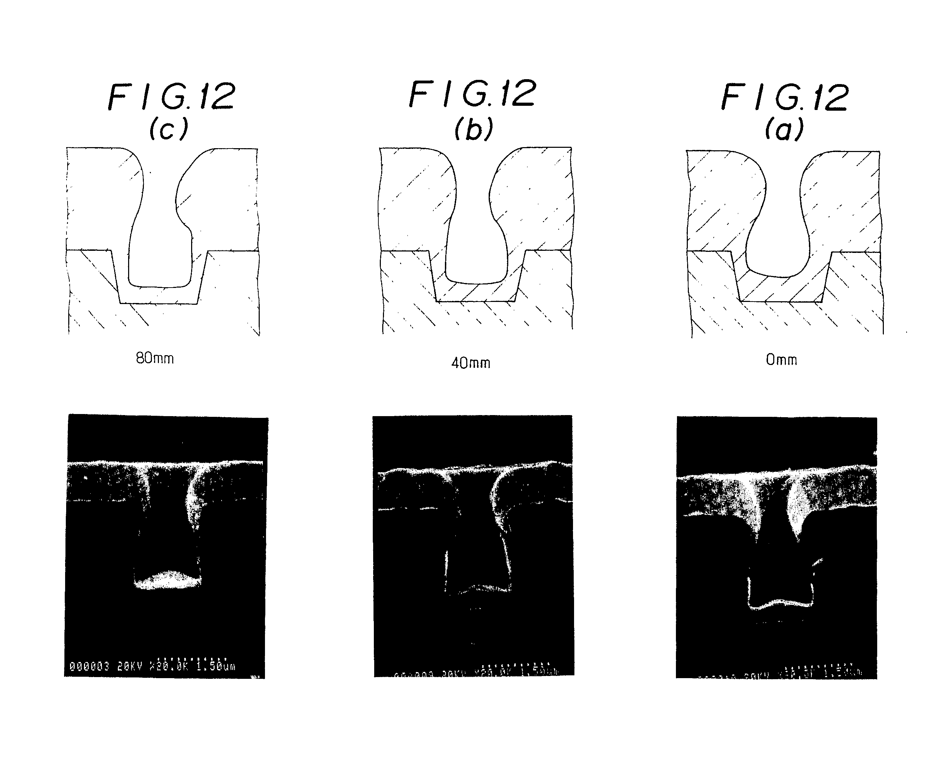

The figures shown on the opposite sides of the contact hole schmatic drawing in Fig. 8 (a), (b) and (c) represent the characteristics of the step coverage, respectively. Those figures show the values of $\ell$ for d = 100, where "d" refers to the thickness of the thin film deposited on the wafer, and " $\ell$ " refers to the thickness of the thin film deposited on the upper end of the inner wall of the contact hole. In Fig. 8 (a), for example, the left-side wall has the value of $\ell = 31.8$ for d = 100. In Fig. 11 (a), (b) and (c), the similar figures are given in the same manner as in Fig. 8, which will be described later.

Fig. 8 and Fig. 9 show that the results obtained from the simulation calculation agree well with the results obtained from the production test.

The running test is also carried out for the magnetron cathode described in the embodiment shown in Figs. 1 through 3.

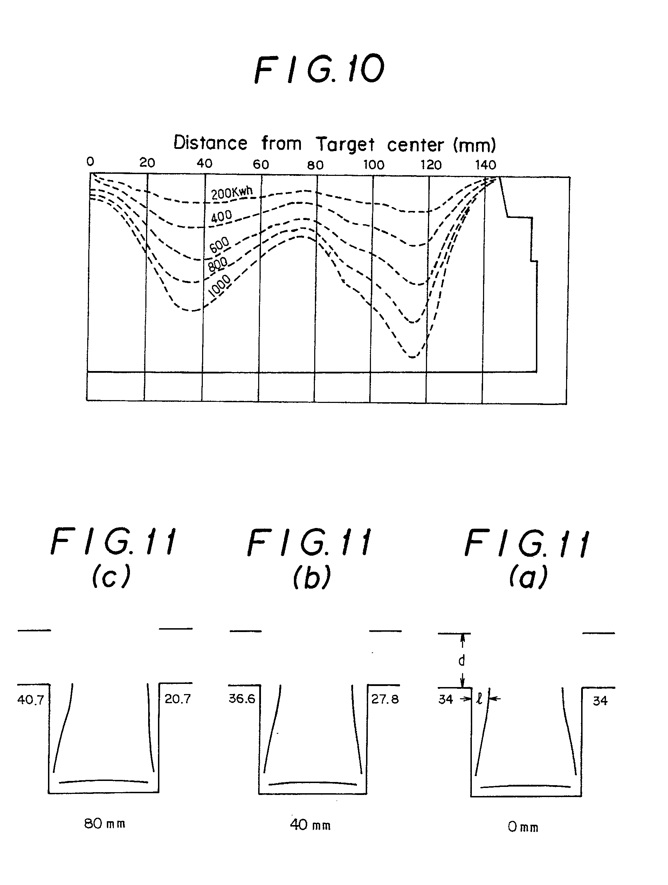

The erosion profile obtained from the running test (1,000 Kwh) is shown in Fig. 10. From this erosion profile, the simulation calculation is performed in the similar way to define the configurations of the thin film deposits contained in the erosion profile, which are shown in Fig. 11 (a), (b) and (c). The SEM photographs and the corresponding schematic cross-section views for the contact holes are given in Fig. 12 (a), (b) and (c), in which the upper part depicts the contact holes drawn from the SEM photographs, and the lower part shows the SEM photographs. As seen from Fig. 11 and Fig. 12, the results from the simulation calculation agree well with those from the production test.

The values for the step coverage given in each contact hole in Fig. 8 and Fig. 11 show that the apparatus in Figs. 1 through 3 can eliminate the irregularities in the step coverage.

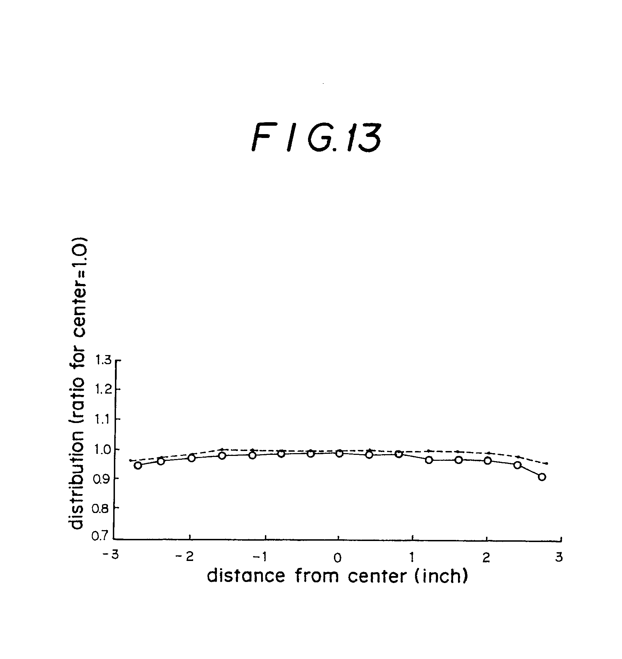

Fig. 13 shows the thin film distribution, which is obtained by using the magnetron cathode shown in Figs. 1 through 3. In Figs. 1 through 3, the solid lines indicate the test results, and the dotted lines indicate the results from the simulation calculation. Those results show the thin film distribution of within ± 5%.

It may be seen from the above results that the magnetron cathode shown in Figs. 1 through 3 can improve the distribution of the thin film to be formed or deposited by the sputtering, and can also improve any irregularities in the step coverage for the contact holes.

Then, the simulation calculation on the above results occur, to define the requirements for the erosion profile that may be provided by the magnetron cathode and which provide the thin film distribution of within ± 5% and the step coverage of within ± 10%. The results obtained from the simulation calculation show that the above requirements can be met when the erosion profile has the peak points of 15/152b to 20/152b and 50/152b to 60/152b located away from the target center (where "b" is the diameter of the target), and the inner and outer erosion strength ratio of 2:3 to 1:1.

The spacing $\underline{a}$ between the wafer and target is 12/61b to 15/61b (where "b" is the diameter of the target).

It may be understood from the foregoing description that the magnetron sputtering apparatus according to the present invention can provide the increased magnetic field strength around the center area of the circular target surface, thereby eliminating any dust particles that may settle on the target. Thus, the apparatus can provide the wafer or each individual substrate thereon that has the thin films formed or deposited by the sputtering process, containing no defects such as pin holes.

The method of forming or depositing a thin film by using the magnetron sputtering apparatus of the invention allows the atoms emitted from the target material by sputtering to be directed onto the wafer or each individual substrate thereon in the consistent manner. The method also eliminates any irregularities in the coverage for the contact holes that may have the high aspect ratio, and provides the thin film distribution of within ± 5%. Thus, the method may reliably apply to the manufacture of any semiconductor devices, that must meet the high density and high integration requirements.

Although the present invention has been described with particular reference to the several preferred embodiments thereof, it should be understood that various changes and modifications may be made within the scope and spirit of the invention.

## Claims

1. In a magnetron sputtering apparatus that includes:

   a circular target plate;

   magnetic field generating means (3) disposed behind the circular target plate (2) and including a center magnetic pole (5) and a ring-shaped magnetic pole (6) arranged around the outer circumference of the center magnetic pole (5), the center magnetic pole (5) and the ring-shaped magnetic pole (6) being coupled on a yoke (7); and

   means for causing rotation of the magnetic field generating means, the improvement including:

   a) said center magnetic pole means (5) being off laterally toward one side from the center axis of rotation (4,15) of the magnetic field generating means (3);

   b) first auxiliary magnet means (8,8a) having an identical polarity to said center magnetic pole (5) and disposed on the other side, opposite to said one side on which said center magnetic pole (5) is located, of said center magnetic pole;

   c) second auxiliary magnet means (9) having an identical polarity to said ring-shaped magnetic pole (6) means and disposed on the outer circumference of said ring-shaped magnetic pole (6) and adjacently to said center magnetic pole on said one side on which said center magnetic pole is located;

d) two third auxiliary magnet means (10a,10b) each having an identical polarity to said ring-shaped magnetic pole and disposed on the inner circumference of said ring-shaped magnetic pole on the opposite lateral sides thereof located perpendicularly to the direction in which said center magnetic pole is off;

e) fourth auxiliary magnet means (11) having an identical polarity to said ring-shaped magnetic pole and disposed on the inner circumference on the side opposite the side on which said auxiliary magnetic pole (8) is located;

f) fifth auxiliary magnet means (12) having an identical polarity and integrated with the inner edge of said fourth auxiliary magnet means (11); thereby all of said auxiliary magnet means providing a combined magnetic field strength for the center areas on the circular target plate surface, when the magnetic field generating means (3) is rotated.

2. A magnetron sputtering apparatus as defined in claim 1, wherein said first auxiliary magnet pole (18a) on said center magnet pole (5) is located in the position deviating from said center axis of rotation (15) of the magnetic field generating means (3).

3. A magnetron sputtering apparatus as defined in claim 1 or 2, wherein said center magnet means (5) provides a south (S) polarity, and said ring-shaped magnet means (6) provides a north (N) polarity.

4. A magnetron sputtering apparatus as defined in one of claims 1 to 3, wherein said first auxiliary magnet means (8,8a) through said fifth auxiliary magnet means (12) each comprise a plate magnet.

5. A method of forming or depositing a thin film on a wafer (1) or individual substrates thereon by making use of the magnetron sputtering apparatus, said magnetron sputtering apparatus including:
circular target plate (2);
magnetic field generating means (3) disposed behind the circular target plate (2) and including a center magnetic pole (5) and a ring-shaped magnetic pole (6) disposed around the outer circumference of the center magnetic pole (5), the center magnetic pole (5) and the ring-shaped magnetic pole (6) being coupled on a yoke (7); and
means for causing rotation of the magnetic field generating means, wherein the apparatus further includes:
said center magnetic pole means (5) being off laterally toward one side from the center axis of rotation (4,15) of the magnetic field generating means (3);
first auxiliary magnet means (8,8a) having an identical polarity to said center magnetic pole (5) and disposed on the other side, opposite to said one side on which center magnetic pole (5) is located, of said center magnetic pole;
second auxiliary magnet means (9) having an identical polarity to said ring-shaped magnetic pole means (6) and disposed on the outer circumference of said ring-shaped magnetic pole (6) and adjacently to said center magnetic pole (5) on said one side on which said center magnetic pole is located; two third auxiliary magnet means (10a,10b) each having an identical polarity to said ring-shaped magnetic pole (6) and disposed on the inner circumference of said ring-shaped magnetic pole (6) on the opposite lateral sides thereof located perpendicularly to the direction in which said center magnetic pole (5) is off;
fourth auxiliary magnet means (11) having an identical polarity to said ring-shaped magnetic pole (6) and disposed on the inner circumference on the side opposite the side on which said first auxiliary magnetic pole (8) is located;
fifth auxiliary magnet means (12) having an identical polarity and integrated with the inner edge of said fourth auxiliary magnet means (11); thereby all of said auxiliary magnet means providing a combined magnetic field strength for the center areas on the circular target plate surface, when the magnetic field generating means (3) is rotated;
wherein the method comprises:
providing an erosion on the circular target plate (2), having a profile composed of a double concentric circle including an inner circle (13) and an outer circle (14) having the peak points of 15/152b to 20/152b and 50/152b to 60/152b (where "b" is the diameter of the circular target plate), respectively, said inner circle (13) and said outer circle (14) having the erosion strength ratio of between 2:3 and 1:1 at each peak point.

6. A method as defined in claim 5, wherein the distance between the wafer (1) and the circular target plate (2) is in the range of between 12/61b and 15/61b (where "b" is the diameter of the circular target plate (2).

# F I G. 1

# F I G. 2

# FIG. 2a

# FIG. 3

# F I G. 4

Point (cm)

# F I G. 5

Point (cm)

EP 0 444 658 A2

FIG. 6

Number of particles after sputtering (particles per 6-inch$\phi$, for a particle 0.28 $\mu$m or more in diameter)

Diameter of non-erosion region in target center [mm]

12

# F I G. 7

Distance from Target center (mm)

200kwh
400
600
800
1000

# F I G. 8
## (c)

# F I G. 8
## (b)

# F I G. 8
## (a)

38.3    12.8

32.7    25.1

31.8    31.9

80 mm      40 mm      0 mm

EP 0 444 658 A2

FIG. 9
(c)

FIG. 9
(b)

FIG. 9
(a)

80mm

40mm

0mm

# F I G. 10

Distance from Target center (mm)

# F I G. 11 (c)

80 mm

# F I G. 11 (b)

40 mm

# F I G. 11 (a)

0 mm

# F I G.12
## (c)

80mm

000003 20KV X20.0K 1.50um

# F I G.12
## (b)

40mm

# F I G.12
## (a)

0mm

EP 0 444 658 A2

# F I G.13

distribution (ratio for center=1.0)

distance from center (inch)

# F I G.14

## PRIOR ART

62

68

69

63

64

65

67

66

# F I G.15

## PRIOR ART

66

64

67

65

## F I G.16
### PRIOR ART

## F I G.17
### PRIOR ART